# EUROPEAN PATENT APPLICATION

(11) **EP 0 532 139 A1**
(43) Date of publication of application: **17.03.1993**
(21) Application number: 92250247.1
(22) Date of filing: 04.09.1992
(51) Int. Cl.: C04B 35/00, H01L 23/15

(54) **Clean burning green ceramic tape cast system**

(30) Priority: 11.09.1991 US 758917
(71) Applicant: W.R. Grace & Co.-Conn., New York, New York 10036 (US)
(72) Inventor: Lau, John Wing-Keung, Gaithersburg, MD 20878 (US)
(74) Representative: UEXKÜLL & STOLBERG

(57) **Abstract**

Green ceramic formulations comprising polymethacrylate binders are suitable for tape casting and can be effectively removed during thermal processing in reducing atmospheres. Preferred binders are polyalkylmethacrylates. The binder may be removed in substantially dry reducing atmosphere. The tapes may be used for forming ceramic substrates and metallized ceramics such as those used in electronic packaging.

## Description

### Background of the Invention

In making ceramic-based electronic packages for housing integrated circuits and in the production of other ceramic products, it is often desirable to have the option of using a reducing atmosphere for thermal processing of the ceramic material(s). In some circumstances, the use of a reducing atmosphere may be necessary to avoid unwanted oxidation (of the ceramic and/or any co-fired metals) and to obtain a useful product.

In the manufacture of many ceramic products, such as ceramic-based electronic packages, the ceramic powder is combined with a binder and formed into a green ceramic tape. Metals may optionally be placed on the tape surface and/or at locations in the tape by known metallization techniques. A series of the green tapes are then laminated and fired to produce a densified ceramic product (e.g. a dense ceramic base for use in an electronic package.)

Green ceramic tapes can be formed in a variety of ways such as by tape casting or by extrusion. Tape casting is the most widely used and generally preferred technique from an economic standpoint.

When green ceramic tapes are used to form dense ceramic products, the binder in the green tape is typically removed during thermal processing of the tape laminate. While complete removal of the binder is generally preferred (especially for ceramics used in electronic packaging), often residual material such as components and/or reaction products from the binder can remain in the ceramic. For organic binders, a typical residual material is elemental carbon. Residual elemental carbon is generally a less prevalent problem for ceramics that are processed in oxidizing atmospheres. Oxygen can react with the binder and/or residual carbon to form gaseous materials that can escape from the green tape laminate.

For ceramics processed in reducing atmospheres, the problem of residual materials (e.g. carbon) is more difficult to overcome. Generally, effective binder removal can only be accomplished by use of some sort of binder removal catalyst, by use of a prolonged low temperature heating schedule, by use of wet gas atmospheres (e.g. U.S. Patent 4,234,367) or by use of a special binder.

Catalysts add expense to the process and may also leave undesirable trace materials (especially if the ceramic is to be used in electronic packaging.) Prolonged heating schedules add significantly to the cost of production and may only be marginally effective. Wet gases, even when they contain hydrogen, may produce undesired oxidation and/or may require elaborate control of heating and atmosphere conditions. While special binder systems have been used to overcome this problem (e.g. polyethylene used in U.S. Patent 4,920,640), such special binders are generally not amenable to formation of green tapes by tape casting.

Accordingly, there remains a need for green tape formulations which are amenable to tape casting and which can be effectively removed from a green ceramic laminate during thermal processing in reducing atmospheres without the use of catalysts, prolonged heating schedules or wet gases.

### Summary of the Invention

The invention provides green ceramic formulations suitable for tape casting which contain binders that can be effectively removed during thermal processing in reducing atmospheres. The invention further provides improved methods for making dense ceramic products using reducing atmospheres for thermal processing.

In one aspect, the invention encompasses a green ceramic composition for casting green ceramic tape, the composition comprising:
a) ceramic particles, and
b) a polymethacrylate binder.
In a further aspect, the composition may also comprise:
c) a dispersant,
d) a plasticizer, and
e) a solvent.

Polyalkylmethacrylates are preferred binders, especially those selected from the group consisting of polymethylmethacrylate, polybutylmethacrylate, polyethylmethacrylate, and mixtures or copolymers thereof.

The invention also encompasses a method for forming a dense ceramic, the method comprising:
a) combining ceramic powder, a dispersant, a plasticizer, a solvent and a polymethacrylate binder to form a slip,
b) casting the slip onto a sheet to form a tape,
c) recovering the tape from the sheet, and
d) heating the tape in a reducing atmosphere to remove the binder and densify the ceramic.

The method may also include forming a laminate containing a plurality of tape layers which is processed in step d) to produce a ceramic product. The tape layers may be metallized prior to lamination. In a more specific aspect, the invention also encompasses forming dielectric ceramic bases useful in electronic packaging using the tape formulation and method of the invention. The ceramic particles are preferably selected from the group consisting of alumina, aluminum nitride, mullite, glass-ceramics and glasses.

### Detailed Description of the Invention

The green ceramic composition for casting green ceramic tape comprise:
a) ceramic particles, and
b) a polymethacrylate binder.
The compositions preferably further comprise:
c) a dispersant,
d) a plasticizer, and
e) a solvent.

The ceramic particles may be any ceramic material such alumina, aluminum nitride, mullite, glass-ceramics and glasses, or mixtures thereof. The particles are preferably of a suitable size to facilitate densification and other processing steps which the tape may undergo. For example, in forming electronic packaging, the tape may be punched or have metallization screened on its surface.

The polymethacrylate binder is preferably a polyalkylmethacrylate, especially those selected from the group consisting of polymethylmethacrylate, polybutylmethacrylate, polyethylmethacrylate, and mixtures or copolymers thereof. The preferred binders are sold under the trade names "Acryloid® B7" and "Acryloid® B66" by Rohm and Haas Corp. and as "Elvacite® 2044" by Dupont. The amount of binder used is preferably kept to the minimum necessary to produce a useful green tape. The binder preferably forms about 5-15 wt.% of the tape composition based on the weight of the ceramic particles.

The tape composition preferably contains a dispersant to facilitate mixing of the binder and ceramic particles. The dispersant should be compatible with the other ingredients of the tape composition and should not leave any undesired residue in subsequent processing. Glycerol trioleate is a preferred dispersant. Mixtures of suitable dispersants may be used if desired. As with the binder, the amount of dispersant used is preferably the minimum necessary to easily achieve a usable tape. Preferably, the dispersant forms about 0.25-2.0 wt.% of the composition based on the weight of the ceramic particles.

The tape composition also preferably contains a plasticizer which generally improves the workability of the tape before and after casting. The plasticizer should be compatible with the other ingredients of the tape composition and should not leave any undesired residue in subsequent processing. Preferred plasticizers are polyethylene glycols and phthalates such as dioctyl phthalate and dibutyl benzyl phthalate. Mixtures of appropriate plasticizers may be used. As with the binder, the amount of plasticizer used is preferably the minimum necessary to easily achieve a workable tape. Preferably, the plasticizer forms about 2-10 wt.% of the composition based on the weight of the ceramic particles.

The tape composition preferably further contains a solvent. The solvent should be compatible with the other ingredients of the tape composition and should not leave any undesired residue in subsequent processing. A preferred solvents comprises toluene and ethanol. As with the binder, the amount of solvent used is preferably the minimum necessary to easily achieve a workable tape. Preferably, the solvent forms about 25-45 vol.% of the composition based on the total slip volume.

The green tape composition may further include any other appropriate expedients known in the tape casting art.

The method of the invention comprises:
a) combining ceramic powder, a dispersant, a plasticizer, a solvent and a polymethacrylate binder to form a slip,
b) casting the slip onto a sheet to form a tape,
c) recovering the tape from the sheet, and
d) heating the tape in a reducing atmosphere to remove the binder and densify the ceramic.
The combining step a) may include the steps:
i) combining the ceramic powder with the dispersant and solvent to form a slip;
ii) mixing plasticizer and polymethacrylate binder with the slip to form a modified slip.
Alternatively, the plasticizer may be combined with the ceramic powder and dispersant in step i).

The slip may be de-aired by applying a vacuum to the slip prior to casting step b).

Recovering step c) preferably includes the steps:
i) drying the tape, and
ii) separating the tape from the sheet.

If a multi-layered ceramic base for use in electronic packaging is desired, a plurality of tapes may be laminated together prior to heating step d). The tape recovered in step c), may optionally be treated to add any appropriate metallization to step d). Examples of useful methods for forming ceramic bases from green tapes are disclosed in U.S. Patents 4,920,640 and 5,017,434 as well as in U.S. Patent Application Serial No. 631,577, filed December 21, 1990 and Serial No. 702,562, filed May 20, 1991, the disclosures of which are incorporated herein by reference.

Typical reducing atmospheres are substantially dry atmospheres comprising about 3-5% H₂ (based on the total pressure) with the balance being a neutral gas such as N₂ or Ar, however the invention is not limited to the use of any particular reducing atmosphere.

In performing the method of the invention, the tape formulation used is preferably one of those described above.

The following example is presented to further illustrate the invention. The invention is not limited to any of the specific details of the example.

### Example

An alumina green tape was prepared as follows:
a) 100 parts (by weight) of ceramic powder were ball milled for 10 hours together with 1 part dispersant, 5 parts plasticizer, and 40 parts solvent to form a well dispersed slip;
b) 5 parts of binder were added to the slip and the mixture was ball milled for 10 additional hours to produce a modified slip;
c) the modified slip was de-aired by applying a vacuum and cast onto a Mylar® sheet using a doctor blade; and
d) the cast slip was dried and separated from the Mylar® sheet to produce a green tape.

The ceramic powder contained 96 wt.% alumina, 3.4 wt.% silica, and 0.6 wt.% magnesia. The dispersant was glycerol trioleate, and the plasticizer was dibutyl benzyl phthalate. The solvent was a azeotropic mixture of 40 wt.% toluene and 60 wt.%. The binder was a methyl, butylmethacrylate copolymer Acryloid® B66 sold by Rohm and Haas.

## Claims

1. A method for forming a dense ceramic article, said method comprising:
a) combining ceramic particles, a dispersant, a plasticizer, a solvent and a polymethacrylate binder to form a slip,
b) casting said slip onto a sheet to form a tape,
c) recovering said tape from said sheet,
d) optionally laminating said tape with other layers of green ceramic tape, and
e) heating said tape or tape laminate in a reducing atmosphere to remove said binder and densify said ceramic.

2. The method of claim 1 wherein step a) comprises:
i) combining said ceramic powder, dispersant and solvent to form a slip;
ii) mixing said plasticizer and said binder into said slip to form said slip for casting in step b).

3. The method of claim 1 wherein step a) comprises:
i) combining said ceramic powder, dispersant, plasticizer and solvent to form a slip, and
ii) mixing said binder into said slip to form said slip for casting in step b).

4. The method of claims 1 to 3 wherein step e) comprises:
i) drying said tape, and
ii) separating said tape from said sheet.

5. The method of claims 1 to 4 wherein said ceramic particles are selected from the group consisting of alumina, aluminum nitride, mullite, glass-ceramics and glasses.

6. The method of claims 1 to 5 wherein metallization is applied to at least one layer of said laminate prior to step d).

7. The method of claims 1 to 6 wherein said ceramic particles are selected from the group consisting of alumina, aluminum nitride, mullite, glass-ceramics and glasses.

8. The method of claims 1 to 7 wherein said slip is de-aired by applying a vacuum to said slip prior to said casting step b).

9. The method of claims 1 to 8 wherein said reducing atmosphere is substantially dry and comprises about 3-5% H₂ based on total pressure with the balance being selected from the group consisting of nitrogen, argon, and mixtures thereof.

10. The method of claims 1 to 9 wherein said slip comprises 25-45vol.% solvent and, in parts by weight, about:
a) 100 parts ceramic powder,
b) 5-15 parts polymethacrylate binder,
c) 0.25-2 parts dispersant, and
d) 2-10 parts plasticizer.
